# EUROPEAN PATENT APPLICATION

(11) **EP 4 283 411 A1**
(43) Date of publication of application: **29.11.2023**
(21) Application number: 21930384.9
(22) Date of filing: 20.12.2021
(51) Int. Cl.: G05B 9/02

(54) **SWITCH SYSTEM AND SWITCH**

(30) Priority: 12.03.2021 JP 2021040144
(71) Applicant: OMRON Corporation, Kyoto 600-8530 (JP)
(72) Inventor: HASHIMOTO, Minoru, Kyoto-shi, Kyoto 600-8530 (JP)
(74) Representative: Isarpatent
(86) International application number: PCT/JP2021/047121
(87) International publication number: WO 2022/190539

(57) **Abstract**

In a switch system, a controller and a plurality of switches are annularly connected by a signal line, and a signal transmitted from the controller to a first switch being one of the plurality of switches is passed through the plurality of switches sequentially and is returned from a second switch being one of the plurality of switches to the controller. Each of the plurality of switches includes an operating body, a detection unit configured to detect proximity of the operating body, a reception unit configured to receive the signal via the signal line, a control unit configured to include, in the signal, proximity information indicating whether the operating body is in proximity to the detection unit, and a transmission unit configured to transmit the signal including the proximity information via the signal line. The signal that the controller receives from the second switch includes the proximity information of each of the plurality of switches.

## Description

### TECHNICAL FIELD

The present invention relates to a switch system and a switch.

### BACKGROUND ART

As a method of connecting a controller and a plurality of switches, there is a method of connecting the plurality of switches to the controller in series. For example, PTL 1 discloses a configuration in which a plurality of non-contact door switches are connected to a high-function unit in series. For example, in the non-contact door switch of PTL 1, a sensor unit attached onto a fixed frame of a door detects separation and proximity of an operating body attached onto the door to be opened and closed, in other words, detects opening and closing of the door.

### CITATION LIST

### PATENT LITERATURE

Patent Literature 1: Japanese Patent No. 4736793

### SUMMARY OF INVENTION

### TECHNICAL PROBLEM

It is known that when the sensor units of all of the non-contact door switches detect proximity of the operating body, a signal including a predetermined pattern is input to the high-function unit, and when a sensor unit of any one of the non-contact door switches does not detect proximity of the operating body, the signal including the predetermined pattern is not input to the high-function unit. Thus, when the non-contact door switches are attached to doors, whether all of the doors are closed can be determined, but an open/closed state of each of the doors cannot be individually determined.

The present invention is made in view of the circumstances described above, and has an object to provide a technique that can determine whether an operating body of each switch is in proximity to a detection unit individually.

### SOLUTION TO PROBLEM

A switch system according to the present disclosure is a switch system including: a controller; a plurality of switches; and a signal line annularly connecting the controller and the plurality of switches, wherein a signal, transmitted from the controller to a first switch being one of the plurality of switches, is passed through the plurality of switches sequentially and returned from a second switch being one of the plurality of switches to the controller, wherein each of the plurality of switches includes an operating body, a detection unit configured to detect proximity of the operating body, a reception unit configured to receive the signal via the signal line, a control unit configured to include, in the signal, proximity information indicating whether the operating body is in proximity to the detection unit, and a transmission unit configured to transmit the signal including the proximity information via the signal line, and the signal that the controller receives from the second switch includes the proximity information of each of the plurality of switches.

The signal that the controller receives includes the proximity information indicating whether the operating body of each of the plurality of switches is in proximity to the detection unit. By analyzing the received signal, the controller can individually determine whether the operating body is in proximity to the detection unit regarding each of the plurality of switches. By attaching each of the plurality of switches to a respective one of a plurality of doors, the controller can individually determine an open/closed state of each door.

A part corresponding to each of the plurality of switches in the signal may include the proximity information of a corresponding switch among the plurality of switches. By analyzing the part corresponding to each of the plurality of switches in the received signal, the controller can individually determine whether the operating body is in proximity to the detection unit regarding each of the plurality of switches.

In the switch system according to the present disclosure, the signal may include a first value and a second value, and the control units of the plurality of switches may each set the part corresponding to each of the plurality of switches in the signal to the first value when the operating body is in proximity to the detection unit, and may each set the part corresponding to each of the plurality of switches in the signal to the second value when the operating body is not in proximity to the detection unit. When the part corresponding to each of the plurality of switches in the received signal has the first value, the controller determines that the operating body is in proximity to the detection unit. When the part corresponding to each of the plurality of switches in the received signal has the second value, the controller determines that the operating body is not in proximity to the detection unit.

In the switch system according to the present disclosure, the first value may be High level and the second value may be Low level. When the part corresponding to each of the plurality of switches in the received signal is High level, the controller determines that the operating body is in proximity to the detection unit, and when the part corresponding to each of the plurality of switches in the received signal is Low level, the controller determines that the operating body is not in proximity to the detection unit. The first value may be Low level, and the second value may be High level. When the part corresponding to each of the plurality of switches in the received signal is Low level, the controller determines that the operating body is in proximity to the detection unit. When the part corresponding to each of the plurality of switches in the received signal is High level, the controller determines that the operating body is not in proximity to the detection unit.

In the switch system according to the present disclosure, the controller may include, in the signal to be transmitted to the first switch, request information for requesting status information indicating a state of a switch of the plurality of switches, the control units of the plurality of switches may each determine whether the status information is requested, based on the request information included in the signal, and when the status information is requested, the control unit may include the status information in the signal, and the signal that the controller receives from the second switch may include the status information of at least one of the plurality of switches. By analyzing the received signal, the controller can acquire the status information of at least one of the plurality of switches.

In the switch system according to the present disclosure, the control units of the plurality of switches may each determine whether a predetermined pattern is included in the signal, and select a first mode when the predetermined pattern is included in the signal and select a second mode when the predetermined pattern is not included in the signal; in the first mode, the control units each may include the proximity information in the signal, and the transmission unit may transmit the signal including the proximity information via the signal line; in the second mode, when the signal is in a first state and the operating body is in proximity to the detection unit, the control unit may maintain the signal in the first state, and the transmission unit may transmit the signal being in the first state via the signal line; in the second mode, when the signal is in the first state and the operating body is not in proximity to the detection unit, the control unit may change the signal to be in a second state, and the transmission unit may transmit the signal being in the second state via the signal line: and in the second mode, when the signal is in the second state, the control unit may maintain the signal in the second state, and the transmission unit may transmit the signal being in the second state via the signal line. By analyzing the received signal, the controller can individually determine whether the operating body is in proximity to the detection unit regarding each of the plurality of switches. By analyzing the received signal, the controller can determine that each operating body of all of the switches is in proximity to the detection unit or that the operating body of at least one of the plurality of switches is not in proximity to the detection unit.

In the switch system according to the present disclosure, the first state may be an ON state and the second state may be an OFF state. In the switch system according to the present disclosure, the first state may be an OFF state. The second state may be an ON state. In the switch system according to the present disclosure, the controller may transmit the signal not including the predetermined pattern to the first switch before transmitting the signal including the predetermined pattern to the first switch. First, the controller transmits the signal not including the predetermined pattern to the first switch, and receives the signal being in the first state or the second state from the second switch. By analyzing the signal being in the first state or the second state, the controller can determine whether each operating body of all of the switches is in proximity to the detection unit. Subsequently, the controller transmits the signal including the predetermined pattern to the first switch, and receives the signal including the proximity information from the second switch. By analyzing the signal including the proximity information, the controller can individually determine whether the operating body is in proximity to the detection unit regarding each of the plurality of switches.

In the switch system according to the present disclosure, the signal line may include a first signal line and a second signal line. The controller may transmit the signal including the predetermined pattern to the first switch via the first signal line, and transmit the signal not including the predetermined pattern to the first switch via the second signal line. The transmission units of the plurality of switches may each transmit the signal including the proximity information via the first signal line, and transmit the signal being in the first state or the second state via the second signal line. A switch according to the present disclosure may be one of the plurality of switches in the switch system, and the switch may be connected to the controller by the signal line. A switch according to the present disclosure may be one of the plurality of switches in the switch system, the switch may be connected to other two of the plurality of switches by the signal line.

A switch according to the present disclosure is a switch in a switch system in which a signal transmitted from a controller to one of a plurality of switches is passed through the plurality of switches sequentially via a signal line annularly connecting the controller and the plurality of switches and is returned from one of the plurality of switches to the controller, the switch including: an operating body; a detection unit configured to detect proximity of the operating body; a reception unit configured to receive the signal via the signal line; a control unit configured to determine whether a predetermined pattern is included in the signal; and a transmission unit configured to transmit the signal via the signal line, wherein the control unit selects a first mode when the predetermined pattern is included in the signal and selects a second mode when the predetermined pattern is not included in the signal, in the first mode, the control unit includes, in the signal, proximity information indicating whether the operating body is in proximity to the detection unit, and the transmission unit transmits the signal including the proximity information via the signal line, in the second mode, when the signal is in a first state and the operating body is in proximity to the detection unit, the control unit maintains the signal in the first state, and the transmission unit transmits the signal being in the first state via the signal line, in the second mode, when the signal is in the first state and the operating body is not in proximity to the detection unit, the control unit changes the signal to be in a second state, and the transmission unit transmits the signal being in the second state via the signal line, and in the second mode, when the signal is in the second state, the control unit maintains the signal in the second state, and the transmission unit transmits the signal being in the second state via the signal line.

The control unit selects the first mode or the second mode, depending on whether the predetermined pattern is included in the received signal. The controller transmits the signal including the predetermined pattern to one of the plurality of switches, and receives the signal including the proximity information from one of the plurality of switches. By analyzing the signal including the proximity information, the controller can individually determine whether the operating body is in proximity to the detection unit regarding each of the plurality of switches. The controller transmits the signal not including the predetermined pattern to one of the plurality of switches, and receives the signal being in the first state or the second state from one of the plurality of switches. By analyzing the signal being in the first state or the second state, the controller can determine whether each operating body of all of the switches is in proximity to the detection unit.

### ADVANTAGEOUS EFFECTS OF INVENTION

According to the present invention, a technique can be provided that enables individual determination as to whether an operating body of each switch is in proximity to a detection unit.

### BRIEF DESCRIPTION OF DRAWINGS

[FIG. 1] FIG. 1 is a block diagram schematically illustrating a configuration of a switch system.
[FIG. 2] FIG. 2 is an explanatory diagram of a communication protocol during a startup time.
[FIG. 3] FIG. 3 is an explanatory diagram of a communication protocol during a normal time.
[FIG. 4] FIG. 4 is an explanatory diagram of a communication protocol when status information is acquired.
[FIG. 5] FIG. 5 is an explanatory diagram of functions of a functional block.

### DESCRIPTION OF EMBODIMENTS

### <Example Use>

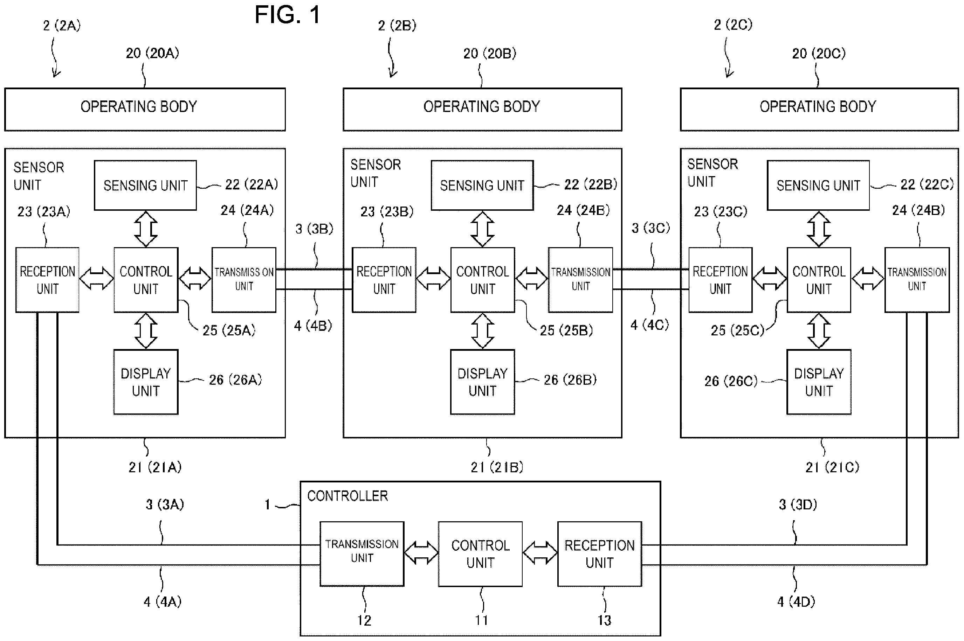

With reference to FIG. 1, an application example of a switch system will be described. FIG. 1 is a block diagram schematically illustrating a configuration of the switch system. The switch system includes a controller 1, a plurality of switches 2, and signal lines 3 and 4 that annularly connect the controller 1 and the plurality of switches 2. Each switch 2 is, for example, a switch of a non-contact type (non-contact switch). FIG. 1 illustrates an example of a configuration in which the switch system includes three switches 2 (2A, 2B, and 2C), and the number of switches 2 may be increased or decreased. The switch system may include two switches 2, or may include four or more switches 2.

The controller 1 and the plurality of switches 2 are annularly connected by the signal lines 3 and 4. The controller 1 and the switch 2A are connected by signal lines 3A and 4A, and the switch 2A and the switch 2B are connected by signal lines 3B and 4B. The switch 2B and the switch 2C are connected by signal lines 3C and 4C, and the switch 2C and the controller 1 are connected by signal lines 3D and 4D. In this manner, the switch 2A (one of the plurality of switches 2) is connected to the controller 1 by the signal lines 3A and 4A, and the switch 2C (one of the plurality of switches 2) is connected to the controller 1 by the signal lines 3D and 4D. The switch 2B (one of the plurality of switches 2) is connected to the switches 2A and 2C (other two of the plurality of switches 2) by the signal lines 3B, 3C, 4B, and 4C.

The controller 1 is an industrial control device such as a programmable logic controller that executes logical arithmetic processing or input/output control processing. The controller 1 may be a safety controller that executes self-diagnostic processing for safety to ensure high safety and reliability.

The controller 1 includes a control unit 11 that generates a pulse signal including a predetermined pattern, a transmission unit 12 that transmits a pulse signal, and a reception unit 13 that receives a pulse signal. The transmission unit 12 transmits a pulse signal to the switch 2A (first switch) being one of the plurality of switches 2 via the signal lines 3A and 4A. The reception unit 13 receives a pulse signal from the switch 2C (second switch) being one of the plurality of switches 2 via the signal lines 3D and 4D, processes the pulse signal, and transmits the pulse signal to the control unit 11. The pulse signal transmitted from the controller 1 to one of the plurality of switches 2 is passed through the plurality of switches 2 sequentially, and is returned from one of the plurality of switches 2 to the controller 1. The pulse signal transmitted from the controller 1 or an upstream switch 2 is received by a downstream switch 2. Then, the controller 1 receives the pulse signal from one of the plurality of switches 2. The pulse signal is an example of a signal.

The switch 2 is, for example, a door switch of a safety door for entrance into and exit from a work area in which surroundings of mechanical equipment such as an industrial robot are separated by a safety fence, a wall, or the like. Each of the plurality of switches 2 includes an operating body 20 and a sensor unit 21. In the configuration example illustrated in FIG. 1, the switch 2A includes an operating body 20A and a sensor unit 21A, the switch 2B includes an operating body 20B and a sensor unit 21B, and the switch 2C includes an operating body 20C and a sensor unit 21C. The operating body 20 is an actuator attached on the side of a door to be opened and closed, for example. The sensor unit 21 is attached onto a fixed frame of the door, for example, and detects separation and proximity of the operating body 20, in other words, detects opening and closing of the door. By attaching each of the switches 2A to 2C to a respective one of a plurality of doors, the switch system illustrated in FIG. 1 can be used as a door switch system for detecting opening and closing of each door. The sensor unit 21 includes a sensing unit 22 as a detection unit that detects proximity of the operating body 20, a reception unit 23 that receives a pulse signal, a transmission unit 24 that transmits a pulse signal, a control unit 25 that performs various types of control, and a display unit 26 that performs predetermined display.

When a distance between the sensing unit 22 and the operating body 20 is a certain value or shorter, the sensing unit 22 detects proximity of the operating body 20. When the sensing unit 22 detects proximity of the operating body 20, the sensing unit 22 transmits a detection signal to the control unit 25, and when the sensing unit 22 no longer detects proximity of the operating body 20, the sensing unit 22 stops transmission of the detection signal to the control unit 25. The control unit 25 performs control, signal processing, arithmetic processing, and the like of each unit of the switch 2. The control unit 25 analyzes the pulse signal transmitted from the reception unit 23.

A reception unit 23A, a transmission unit 24A, a control unit 25A, and a display unit 26A of the switch 2A will be described. The reception unit 23A receives a pulse signal from the controller 1 via the signal lines 3A and 4A, processes the pulse signal, and transmits the pulse signal to the control unit 25A. The control unit 25A determines whether a predetermined pattern is included in the received pulse signal. When the predetermined pattern is included in the received pulse signal, the control unit 25A selects a communication mode (first mode), and generates a pulse signal including proximity information indicating whether the operating body 20A is in proximity to a sensing unit 22A. In this manner, in the communication mode, the control unit 25A includes, in the pulse signal, the proximity information indicating whether the operating body 20A is in proximity to the sensing unit 22A. In accordance with control by the control unit 25A, the transmission unit 24A transmits the pulse signal including the proximity information to the switch 2B via the signal lines 3B and 4B. The display unit 26A displays information indicating that the operating body 20A is in proximity to the sensing unit 22A or information indicating that the operating body 20A is not in proximity to the sensing unit 22A. The display unit 26A may display an open/closed state of the door to which the switch 2A is attached.

A reception unit 23B, a transmission unit 24B, a control unit 25B, and a display unit 26B of the switch 2B will be described. The reception unit 23B receives a pulse signal from the switch 2A via the signal lines 3B and 4B, processes the pulse signal, and transmits the pulse signal to the control unit 25B. The control unit 25B determines whether a predetermined pattern is included in the received pulse signal. When the predetermined pattern is included in the received pulse signal, the control unit 25B selects the communication mode. The pulse signal received from the switch 2A includes proximity information of the switch 2A. The control unit 25B generates a pulse signal including the proximity information of the switch 2A and proximity information indicating whether the operating body 20B is in proximity to a sensing unit 22B. In this manner, in the communication mode, the control unit 25B includes, in the pulse signal, the proximity information of the switch 2A and the proximity information indicating whether the operating body 20B is in proximity to the sensing unit 22B. In accordance with control by the control unit 25B, the transmission unit 24B transmits the pulse signal including the proximity information to one of the plurality of switches 2 (switch 2C) via the signal lines 3C and 4C. The display unit 26B displays information indicating that the operating body 20B is in proximity to the sensing unit 22B or information indicating that the operating body 20B is not in proximity to the sensing unit 22B. The display unit 26B may display an open/closed state of the door to which the switch 2B is attached.

A reception unit 23C, a transmission unit 24C, a control unit 25C, and a display unit 26C of the switch 2C will be described. The reception unit 23C receives a pulse signal from the switch 2B via the signal lines 3C and 4C, processes the pulse signal, and transmits the pulse signal to the control unit 25C. The control unit 25C determines whether a predetermined pattern is included in the received pulse signal. When the predetermined pattern is included in the received pulse signal, the control unit 25C selects the communication mode. The pulse signal received from the switch 2B includes proximity information of the switch 2A and proximity information of the switch 2B. The control unit 25C generates a pulse signal including the proximity information of the switch 2A, the proximity information of the switch 2B, and proximity information indicating whether the operating body 20C is in proximity to a sensing unit 22C. In this manner, in the communication mode, the control unit 25C includes, in the pulse signal, the proximity information of the switch 2A, the proximity information of the switch 2B, and the proximity information indicating whether the operating body 20C is in proximity to the sensing unit 22C. In accordance with control by the control unit 25C, the transmission unit 24C transmits the pulse signal including the proximity information to the controller 1 via the signal lines 3D and 4D. The display unit 26C displays information indicating that the operating body 20C is in proximity to the sensing unit 22C or information indicating that the operating body 20C is not in proximity to the sensing unit 22C. The display unit 26C may display an open/closed state of the door to which the switch 2C is attached.

The pulse signal received from the switch 2C includes the proximity information of the switch 2A, the proximity information of the switch 2B, and the proximity information of the switch 2C. By analyzing the pulse signal received from the switch 2C, the controller 1 can individually determine whether the operating body 20A is in proximity to the sensing unit 22A, whether the operating body 20B is in proximity to the sensing unit 22B, and whether the operating body 20C is in proximity to the sensing unit 22C. By attaching each of the switches 2A to 2C to a respective one of a plurality of doors, the controller 1 can individually determine the open/closed state of each door.

FIG. 1 illustrates an example using the signal lines 3 and 4, however only one of the signal line 3 and the signal line 4 may also be used. The signal line 3 may be used as a first signal line for transmitting the pulse signal, and the signal line 4 may be used as a second signal line for transmitting a digital I/O signal (ON/OFF signal). The ON/OFF signal is an example of a signal.

A case will be described in which the signal line 3 is used as the first signal line for transmitting the pulse signal and the signal line 4 is used as the second signal line for transmitting the digital I/O signal. The transmission unit 12 of the controller 1 transmits the pulse signal including a predetermined pattern to the switch 2A via the signal line 3A, and transmits the digital I/O signal not including the predetermined pattern to the switch 2A via the signal line 4A. Regarding the case in which the signal line 3 is used as the first signal line for transmitting the pulse signal, operations of the controller 1 and the plurality of switches 2 are as described above, and thus details thereof will be omitted.

A case will be described in which the signal line 4 is used as the second signal line for transmitting the digital I/O signal. The controller 1 transmits an ON signal to the switch 2A as the digital I/O signal. In other words, the controller 1 transmits the ON/OFF signal being in an ON state to the switch 2A. The ON state is an example of a first state, and the OFF state is an example of a second state. A relationship between ON and OFF may be interchanged. The controller 1 may transmit the ON/OFF signal being in an OFF state to the switch 2A. The ON state is an example of a second state, and the OFF state is an example of a first state. A relationship between ON and OFF may be interchanged similarly for operations of the switches 2A to 2C described below. The reception unit 23A of the switch 2A receives the digital I/O signal from the controller 1 via the signal line 4A, processes the digital I/O signal, and transmits the digital I/O signal to the control unit 25A.

The control unit 25A determines whether a predetermined pattern is included in the received digital I/O signal. When the predetermined pattern is not included in the received digital I/O signal, the control unit 25A selects a digital I/O mode (second mode). Because the digital I/O signal does not include the predetermined pattern, the control unit 25A selects the digital I/O mode. In the digital I/O mode, when the digital I/O signal is in the ON state and the operating body 20A is in proximity to the sensing unit 22A, the control unit 25A maintains the digital I/O signal in the ON state. In accordance with control by the control unit 25A, the transmission unit 24A transmits the digital I/O signal being in the ON state to the switch 2B via the signal line 4B. In the digital I/O mode, when the digital I/O signal is in the ON state and the operating body 20A is not in proximity to the sensing unit 22A, the control unit 25A changes the digital I/O signal to be in the OFF state. In accordance with control by the control unit 25A, the transmission unit 24A transmits the digital I/O signal being in the OFF state to the switch 2B via the signal line 4B. In the digital I/O mode, when the digital I/O signal is in the OFF state, the control unit 25A maintains the digital I/O signal in the OFF state. In accordance with control by the control unit 25A, the transmission unit 24A transmits the digital I/O signal being in the OFF state to the switch 2B via the signal line 4B.

The reception unit 23B of the switch 2B receives the digital I/O signal from the switch 2A via the signal line 4B, processes the digital I/O signal, and transmits the digital I/O signal to the control unit 25B. The control unit 25B determines whether a predetermined pattern is included in the received digital I/O signal. Because the digital I/O signal does not include the predetermined pattern, the control unit 25B selects the digital I/O mode. In the digital I/O mode, when the digital I/O signal is in the ON state and the operating body 20B is in proximity to the sensing unit 22B, the control unit 25B maintains the digital I/O signal in the ON state. In accordance with control by the control unit 25B, the transmission unit 24B transmits the digital I/O signal being in the ON state to the switch 2C via the signal line 4C. In the digital I/O mode, when the digital I/O signal is in the ON state and the operating body 20B is not in proximity to the sensing unit 22B, the control unit 25B changes the digital I/O signal to be in the OFF state. In accordance with control by the control unit 25B, the transmission unit 24B transmits the digital I/O signal being in the OFF state to the switch 2C via the signal line 4C. In the digital I/O mode, when the digital I/O signal is in the OFF state, the control unit 25B maintains the digital I/O signal in the OFF state. In accordance with control by the control unit 25B, the transmission unit 24B transmits the digital I/O signal being in the OFF state to the switch 2C via the signal line 4C.

Regarding the switch 2C as well, after processing similar to that of the switch 2B is performed, the transmission unit 24C transmits, in accordance with control by the control unit 25C, the digital I/O signal being in the ON state or OFF state to the controller 1 via the signal line 4D. The controller 1 determines whether the digital I/O signal received from the switch 2C is in the ON state or OFF state. When the digital I/O signal is in the ON state, the controller 1 determines that each operating body 20 of all of the switches 2 is in proximity to the sensing unit 22. When the digital I/O signal is in the OFF state, the controller 1 determines that the operating body 20 of at least one of the plurality of switches 2 is not in proximity to the sensing unit 22.

By analyzing the digital I/O signal received from the switch 2C, the controller 1 can determine that each operating body 20 of all of the switches 2 is in proximity to the sensing unit 22 or that the operating body 20 of at least one of the plurality of switches 2 is not in proximity to the sensing unit 22. By attaching each of the switches 2A to 2C to a respective one of a plurality of doors, the controller 1 can determine that all of the doors are in a closed state or that at least one of the plurality of doors is in an open state.

When the controller 1 individually determines the open/closed state of each door, the controller 1 transmits the pulse signal including the predetermined pattern to the switch 2A, and receives the pulse signal including the proximity information from the switch 2C. By analyzing the signal including the proximity information, the controller 1 can individually determine whether the operating body 20 is in proximity to the sensing unit 22 regarding each of the plurality of switches 2. Thus, by analyzing the pulse signal including the proximity information, the controller 1 can individually determine the open/closed state of each door. When the controller 1 determines whether all of the doors are in the closed state, the controller 1 transmits the digital I/O signal not including the predetermined pattern to the switch 2A, and receives the digital I/O signal being in the ON state or OFF state from the switch 2C. By analyzing the digital I/O signal being in the ON state or OFF state, the controller 1 can determine whether each operating body 20 of all of the switches 2 is in proximity to the sensing unit 22. Thus, the controller 1 can determine whether all of the doors are in the closed state.

Processing time during which each switch 2 processes the pulse signal is longer than processing time during which each switch 2 processes the digital I/O signal. When the controller 1 simultaneously performs processing of transmitting the pulse signal to the switch 2A and processing of transmitting the digital I/O signal to the switch 2A, the controller 1 receives the digital I/O signal before receiving the pulse signal from the switch 2C. The controller 1 may transmit the digital I/O signal not including the predetermined pattern to the switch 2A before transmitting the pulse signal including the predetermined pattern to the switch 2A. First, the controller 1 transmits the digital I/O signal not including the predetermined pattern to the switch 2A and receives the digital I/O signal being in the ON state or OFF state from the switch 2C, and can thereby determine whether all of the doors are in the closed state. Thus, safety control such as operation permission control and operation stop control for the mechanical equipment can be promptly performed. Subsequently, the controller 1 transmits the pulse signal including the predetermined pattern to the switch 2A and receives the pulse signal including the proximity information from the switch 2C, and can thereby individually determine the open/closed state of each door. In this manner, by executing safety control using the signal line 4 as the second signal line for transmitting the digital I/O signal, response processing of the entire safety system is enhanced.

### <Device Configuration>

With reference to FIG. 1, a configuration of the controller 1 and the switches 2 will be described. The controller 1 transmits a pulse signal to one of the plurality of switches 2 and receives a pulse signal from one of the plurality of switches 2, and thereby monitors the plurality of switches 2. As illustrated in FIG. 1, the controller 1 and the plurality of switches 2 are annularly connected. In other words, the controller 1 and the plurality of switches 2 are connected in series. For example, when the controller 1 and each of the switches 2 are directly connected, the controller 1 needs to include as many terminals as the number of switches 2 to be connected. In a system configuration of the present embodiment, the controller 1 and the plurality of switches 2 are connected in series, and therefore the number of terminals of the controller 1 can be reduced.

The controller 1 analyzes the pulse signal received from the switches 2, and performs safety control. The safety control by the controller 1 when each of the switches 2A to 2C is attached to a respective one of a plurality of doors will be described.

First, a case will be described in which information indicating that the operating body 20A is in proximity to the sensing unit 22A, information indicating that the operating body 20B is in proximity to the sensing unit 22B, and information indicating that the operating body 20C is in proximity to the sensing unit 22C are included in the pulse signal that the controller 1 receives from the switch 2C. In this case, the controller 1 determines that all of the plurality of doors are closed, and transmits an operation permission signal to the mechanical equipment such as an industrial robot.

Next, a case will be described in which information indicating that the operating body 20A is in proximity to the sensing unit 22A, information indicating that the operating body 20B is in proximity to the sensing unit 22B, and information indicating that the operating body 20C is not in proximity to the sensing unit 22C are included in the pulse signal that the controller 1 receives from the switch 2C. In this case, the controller 1 determines that the door to which the switch 2A is attached and the door to which the switch 2B is attached are closed, determines that the door to which the switch 2C is attached is open, and transmits an operation stop signal to the mechanical equipment.

The control unit 11 performs control, signal processing, arithmetic processing, and the like of each unit of the controller 1. The control unit 11 may be configured with, for example, a computer including an MPU or a CPU (processor), a RAM, a non-volatile storage device (for example, a ROM, a flash memory, or the like), or the like. The computer may be of any type. All or a part of functions provided by the control unit 11 may be configured with a circuit such as an ASIC and an FPGA. The control unit 11 loads a communication program stored in the storage device in a RAM, and executes data communication in accordance with a predetermined communication protocol with the plurality of switches 2.

Each switch 2 may be a non-contact switch of a magnetic detection type, or may be a non-contact switch of an electromagnetic induction type. With the magnetic detection type, the sensing unit 22 detects magnetism emitted from the operating body 20, and the sensing unit 22 thereby detects separation and proximity of the operating body 20. With the electromagnetic induction type, the sensing unit 22 detects presence of the operating body 20 on the basis of a variation of a degree of magnetic coupling, and detects separation and proximity of the operating body 20. The reception unit 23 and the transmission unit 24 of the switch 2 may perform self-diagnostic processing. The self-diagnostic processing is, for example, processing for diagnosing whether an own unit has an anomaly. Each of the reception unit 23 and the transmission unit 24 transmits information indicating that the own unit has an anomaly to the control unit 25 if the own unit has an anomaly.

The control unit 25 of the switch 2 performs control, signal processing, arithmetic processing, and the like of each unit of the switch 2. The control unit 25 may be configured with, for example, a computer including an MPU or a CPU (processor), a RAM, a non-volatile storage device (for example, a ROM, a flash memory, or the like), or the like. The computer may be of any type. The control unit 25 may include a plurality of MPUs or a plurality of CPUs, and reciprocal monitoring may be performed with the plurality of MPUs or the plurality of CPUs. All or a part of functions provided by the control unit 25 may be configured with a circuit such as an ASIC and an FPGA.

### <Communication Protocol>

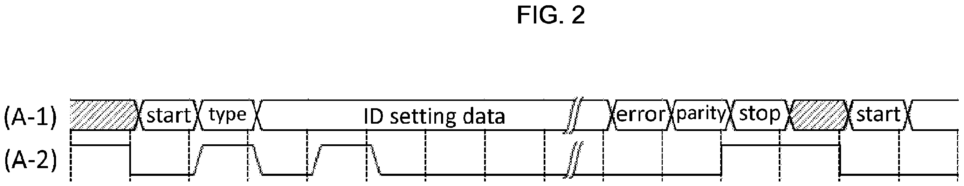

A communication protocol employed by the switch system will be described. First, with reference to FIG. 2, a communication protocol during a startup time will be described. Examples of the startup time include a time during which the controller 1 and the plurality of switches 2 are connected and startup processing is performed when the controller 1 and the plurality of switches 2 are turned on, and a predetermined time after the startup processing. (A-1) of FIG. 2 is an example of a format of the communication protocol during the startup time. (A-2) of FIG. 2 is an example of a waveform (communication waveform) of a signal received by the switch 2B during the startup time. As illustrated in FIG. 2, information indicating start of data transmission (start part) is added to the head of data, and information indicating end of data transmission (stop part) is added to the tail of the data. A type part is information for determining a startup time mode or a normal time mode. In FIG. 2, the type part in the pulse signal is at a High level, and thus the switch 2B recognizes that the current mode is the startup time mode.

An ID setting data part is information for determining an ID number of each of the plurality of switches 2. Each switch 2 recognizes that a number corresponding to the High level part of the ID setting data part is the ID number for the switch 2 itself. In FIG. 2, the second part of the ID setting data part is at a High level, and thus the switch 2B recognizes that the ID number for the switch 2B is "2". The data length of the ID setting data part is fixed, and depends on the maximum number of switches 2 allowed to be connected in the system.

The switch 2B continues to output the pulse signal indicating that the ID setting data part is entirely at a Low level and the ID number is uncertain, until the switch 2B receives the pulse signal including the start part from the switch 2A. The switch 2B receives the pulse signal including the start part from the switch 2A, and recognizes that the type part in the pulse signal is at a High level. The control unit 25B of the switch 2B changes the second part of the ID setting data part of the pulse signal to be at a Low level, and changes the third part of the ID setting data part of the pulse signal to be at a High level. Then, the transmission unit 24B of the switch 2B transmits the pulse signal including the start part to the stop part illustrated in FIG. 2 to the switch 2C. As illustrated in FIG. 2, the pulse signal may include an error part and a parity part. The error part is information used when an error occurs. For example, each switch 2 changes the error part of the pulse signal from Low level to High level when an anomaly occurs in the switch 2. The parity part is a command used for error detection. For example, when each switch 2 performs error detection for a received pulse signal and detects an error in the received pulse signal, the switch 2 changes the error part of the pulse signal from Low level to High level.

The switch 2C that has received the pulse signal from the switch 2B changes the third part of the ID setting data part of the pulse signal to be at a Low level and changes the fourth part of the ID setting data part of the pulse signal to be at a High level, and then transmits the pulse signal to the controller 1. In this manner, each switch 2 that has received the pulse signal changes the part corresponding to the ID number for the switch 2 itself of the ID setting data part of the pulse signal to be at a Low level and changes the part corresponding to an ID number for the subsequent switch (downstream switch) of the ID setting data part of the pulse signal to be at a High level, and then transmits the pulse signal.

The controller 1 determines whether the High level part of the ID setting data part of the pulse signal received from the switch 2C corresponds to a number obtained by adding 1 to the number of connected switches 2. When the High level part of the ID setting data part of the pulse signal does not correspond to the number obtained by adding 1 to the number of connected switches 2, the controller 1 determines that the communication has an anomaly, and transmits the operation stop signal to the mechanical equipment. When the type part of the pulse signal received from the switch 2C is at Low level or the error part of the pulse signal received from the switch 2C is at High level, the controller 1 determines that the communication or the switch 2 has an anomaly, and transmits the operation stop signal to the mechanical equipment.

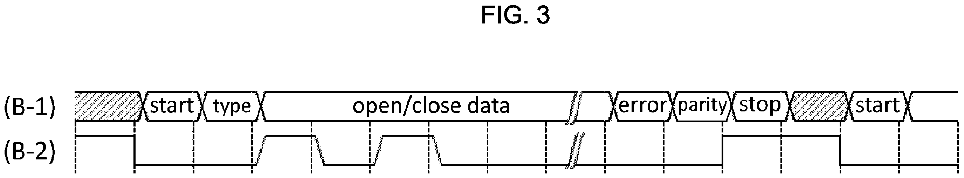

Next, with reference to FIG. 3, a communication protocol during a normal time will be described. Examples of the normal time include a period of time after communication in accordance with the communication protocol during the startup time is executed between the controller 1 and the plurality of switches 2. (B-1) of FIG. 3 is an example of a format of the communication protocol during the normal time. (B-2) of FIG. 3 is an example of a waveform of a signal received by the controller 1 during the normal time. As illustrated in (B-2) of FIG. 3, in a case of the normal time mode, the type part of the pulse signal is set to be at a Low level.

In a case of the normal time mode, each switch 2 includes the proximity information in the part corresponding to the ID number for the switch 2 itself of an open/close data part of the pulse signal and updates the parity part, and then transmits the pulse signal to a subsequent switch 2 or the controller 1. The data length of the open/close data part of the pulse signal is fixed, and is dependent upon the maximum number of switches 2 allowed to be connected in the system. Similarly to the startup time mode, each switch 2 changes the error part of the pulse signal from Low level to High level when an anomaly occurs in the switch 2. For example, when each switch 2 performs error detection for a received pulse signal and detects an error in the received pulse signal, the switch 2 changes the error part of the pulse signal from Low level to High level.

The pulse signal of FIG. 3 includes information indicating that the operating body 20 of a first switch 2 is in proximity to the sensing unit 22, information indicating that the operating body 20 of a third switch 2 is in proximity to the sensing unit 22, and information indicating that the operating body 20 of the other switches 2 is not in proximity to the sensing unit 22. In other words, information indicating that the operating body 20 is in proximity to the sensing unit 22 is the High level part of the open/close data part of the pulse signal, and information indicating that the operating body 20 is not in proximity to the sensing unit 22 is the Low level part of the open/close data part of the pulse signal.

Here, a case will be described in which the operating body 20A of the switch 2A is in proximity to the sensing unit 22A, the operating body 20C of the switch 2C is in proximity to the sensing unit 22C, and the operating body 20B of the switch 2B is not in proximity to the sensing unit 22B. When the operating body 20A is in proximity to the sensing unit 22A, the control unit 25A of the switch 2A sets the part corresponding to the switch 2A (first part of the open/close data part) in the pulse signal to be at a High level (first value). When the operating body 20C is in proximity to the sensing unit 22C, the control unit 25C of the switch 2C sets the part corresponding to the switch 2C (third part of the open/close data part) in the pulse signal to be at a High level (first value). When the operating body 20B is not in proximity to the sensing unit 22B, the control unit 25B of the switch 2B sets the part corresponding to the switch 2B (second part of the open/close data part) in the pulse signal to be at a Low level (second value).

When the operating body 20A is in proximity to the sensing unit 22A, the control unit 25A of the switch 2A may set the part corresponding to the switch 2A (first part of the open/close data part) in the pulse signal to be at a Low level (first value). When the operating body 20C is in proximity to the sensing unit 22C, the control unit 25C of the switch 2C may set the part corresponding to the switch 2C (third part of the open/close data part) in the pulse signal to be at a Low level (first value). When the operating body 20B is not in proximity to the sensing unit 22B, the control unit 25B of the switch 2B may set the part corresponding to the switch 2B (second part of the open/close data part) in the pulse signal to be at a High level (second value).

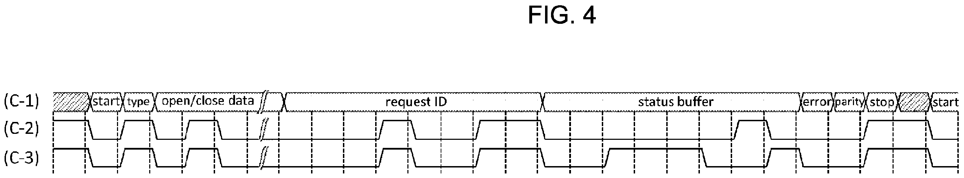

Next, with reference to FIG. 4, a communication protocol when the controller 1 acquires status information of the switch 2 will be described. The status information is information indicating a state of the switch 2, and indicates, for example, a cumulative energization time obtained by accumulating time during which the switch 2 is energized. (C-1) of FIG. 4 is an example of a format of the communication protocol when the controller 1 acquires the status information of the switch 2. (C-2) of FIG. 4 is an example of a waveform of a signal transmitted by the controller 1. (C-3) of FIG. 4 is an example of a waveform of a signal received by the controller 1. As illustrated in FIG. 4, a request ID part and a status buffer part are added following the open/close data part. FIG. 4 illustrates an example in which the status information is requested of a 19th switch 2. For example, the controller 1 executes communication in accordance with the communication protocol for acquiring the status information, instead of the communication protocol during the normal time.

The request ID part is a part used for identifying the ID number of the switch 2 from which the controller 1 requests the status information. 19 (decimal number) = 0x13 (hexadecimal number) = 00010011 (binary number), and accordingly the request ID part of (C-2) of FIG. 4 includes Low, Low, Low, High, Low, Low, High, and High. The status buffer part of the pulse signal transmitted to each switch 2 is a part used for identifying details of the status information. For example, when a number indicating the cumulative energization time is represented by 2 (decimal number) = 0x02 (hexadecimal number) = 00000010 (binary number), the status buffer part of (C-2) of FIG. 4 includes Low, Low, Low, Low, Low, Low, High, and Low.

When the controller 1 requests the cumulative energization time from the 19th switch 2, the controller 1 transmits the pulse signal illustrated in (C-2) of FIG. 4 to the first switch 2. Each switch 2 checks the request ID part of the received pulse signal, and determines whether an ID number identified by the request ID part and the ID number for the switch 2 itself match. When the ID number identified by the request ID part of the pulse signal and the ID number for the switch 2 itself do not match, the switch 2 includes the proximity information in the part corresponding to the ID number for the switch 2 itself of the open/close data part of the pulse signal, updates the parity part of the pulse signal, and then transmits the pulse signal to a subsequent switch 2 or the controller 1. In this case, the switch 2 transmits the pulse signal to the subsequent switch 2 or the controller 1, without changing the status buffer part of the pulse signal.

In contrast, when the ID number identified by the request ID part of the pulse signal and the ID number for the switch 2 itself match, the switch 2 (the 19th switch 2 in the example illustrated in FIG. 4) updates the status buffer part of the pulse signal to the requested data (the cumulative energization time in the example illustrated in FIG. 4). For example, as illustrated in (C-3) of FIG. 4, the 19th switch 2 updates the status buffer part of the pulse signal to the requested cumulative energization time. When the cumulative energization time is 57 hours, 57 (decimal number) = 0x39 (hexadecimal number) = 00111001, and accordingly the status buffer part of the pulse signal of (C-3) of FIG. 4 includes Low, Low, High, High, High, Low, Low, and High. Then, the 19th switch 2 includes the proximity information in the part corresponding to the ID number for the 19th switch 2 of the open/close data part of the pulse signal, updates the parity part of the pulse signal, and then transmits the pulse signal to a subsequent switch 2 or the controller 1. The controller 1 analyzes the status buffer part of the received pulse signal, and acquires requested data (the cumulative energization time in the example illustrated in FIG. 4).

The controller 1 includes, in the pulse signal to be transmitted to the switch 2A, request information for requesting the status information indicating the state of the switch 2, and transmits the pulse signal to the switch 2A. The control unit 25 of each switch 2 determines whether the status information is requested, based on the request ID part included in the pulse signal, and when the status information is requested, the control unit 25 includes the status information in the pulse signal. The controller 1 analyzes the pulse signal received from the switch 2C and checks the status information included in the pulse signal, and can thereby acquire the status information of the switch 2.

In the example illustrated in FIG. 4, a case in which the controller 1 requests the status information from the 19th switch 2 is described, but this example is not limiting and the controller 1 may request the status information from the plurality of switches 2. When the controller 1 requests the status information from the plurality of switches 2, the controller 1 generates the pulse signal including a plurality of request ID parts and a plurality of status buffer parts. For example, the controller 1 generates the pulse signal including the request ID part and the status buffer part for requesting the status information from a 17th switch 2 and the request ID part and the status buffer part for requesting the status information from the 19th switch 2.

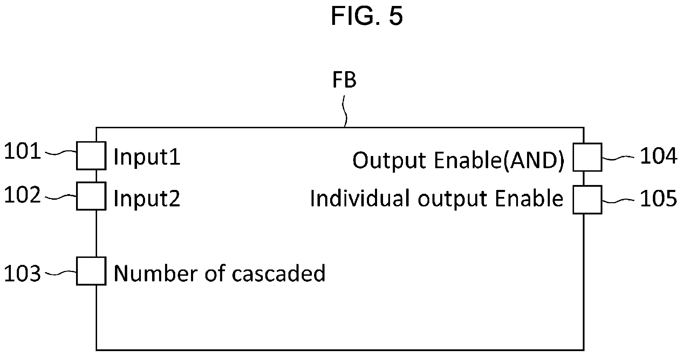

The controller 1 may execute operation of a functional block including functions illustrated in FIG. 5, for example. FIG. 5 is an explanatory diagram of functions of a functional block. The functional block (FB) includes an input unit 101 that receives an input of the pulse signal received via a signal line 3D, an input unit 102 that receives an input of the pulse signal received via a signal line 4D, an input unit 103 that receives inputs as many as the number of switches 2 coupled in series, and output units 104 and 105.

Output of the output units 104 and 105 will be described. Here, a case will be described in which the part corresponding to each switch 2 in the pulse signal is set to a High level value when the operating body 20 is in proximity to the sensing unit 22. When the open/close data part of the pulse signal received by the controller 1 is entirely made up of a High level value, a High level value is output from the output unit 104. When the open/close data part of the pulse signal received by the controller 1 includes a Low level value, a Low level value is output from the output unit 104. Byte data is output from the output unit 105. For example, when the maximum number of switches 2 to be connected is 30, the proximity information of each switch 2 is expressed with each bit of 4-byte (32-bit) data. An output unit 105A (Output Enable (No.1)), an output unit 105B (Output Enable (No.2)), ..., may be provided. By individually outputting the proximity information of each switch 2, usability is enhanced without a user being required to perform bitwise operation.

### <Supplementary Note>

A switch system including a controller (1), a plurality of switches (2), and a signal line (3,4) annularly connecting the controller (1) and the plurality of switches (2), a signal, transmitted from the controller (1) to a first switch (2A) being one of the plurality of switches (2), being passed through the plurality of switches (2) sequentially and being returned from a second switch (2C) being one of the plurality of switches (2) to the controller (1), wherein
each of the plurality of switches (2) includes an operating body (20), a detection unit (22) configured to detect proximity of the operating body (20), a reception unit (23) configured to receive the signal via the signal line (3, 4), a control unit (25) configured to include, in the signal, proximity information indicating whether the operating body is in proximity to the detection unit, and a transmission unit (24) configured to transmit the signal including the proximity information via the signal line, and the signal that the controller (1) receives from the second switch (2C) includes the proximity information of each of the plurality of switches (2).

### REFERENCE SIGNS LIST

1: Controller
2, 2A, 2B, 2C: Switch
3: Signal line
4: Signal line
20: Operating body
21: Sensor unit
22: Sensing unit
23: Reception unit
24: Transmission unit
25: Control unit

## Claims

1. A switch system comprising:
a controller;
a plurality of switches; and
a signal line annularly connecting the controller and the plurality of switches, wherein
a signal, transmitted from the controller to a first switch being one of the plurality of switches, is passed through the plurality of switches sequentially and returned from a second switch being one of the plurality of switches to the controller,
wherein each of the plurality of switches includes an operating body, a detection unit configured to detect proximity of the operating body, a reception unit configured to receive the signal via the signal line, a control unit configured to include, in the signal, proximity information indicating whether the operating body is in proximity to the detection unit, and a transmission unit configured to transmit the signal including the proximity information via the signal line, and
the signal that the controller receives from the second switch includes the proximity information of each of the plurality of switches.

2. The switch system according to claim 1, wherein
a part corresponding to each of the plurality of switches in the signal includes the proximity information of a corresponding switch among the plurality of switches.

3. The switch system according to claim 2, wherein
the signal includes a first value and a second value, and
the control units of the plurality of switches each set the part corresponding to each of the plurality of switches in the signal to the first value when the operating body is in proximity to the detection unit, and set the part corresponding to each of the plurality of switches in the signal to the second value when the operating body is not in proximity to the detection unit.

4. The switch system according to claim 3, wherein
the first value is High level, and
the second value is Low level.

5. The switch system according to claim 3, wherein
the first value is Low level, and
the second value is High level.

6. The switch system according to any one of claims 1 to 5, wherein
the controller includes, in the signal to be transmitted to the first switch, request information for requesting status information indicating a state of a switch of the plurality of switches,
the control units of the plurality of switches each determine whether the status information is requested, based on the request information included in the signal, and when the status information is requested, the control unit includes the status information in the signal, and
the signal that the controller receives from the second switch includes the status information of at least one of the plurality of switches.

7. The switch system according to any one of claims 1 to 6, wherein
the control units of the plurality of switches each determine whether a predetermined pattern is included in the signal, and selects a first mode when the predetermined pattern is included in the signal and selects a second mode when the predetermined pattern is not included in the signal,
in the first mode, the control units each include the proximity information in the signal, and the transmission unit transmits the signal including the proximity information via the signal line,
in the second mode, when the signal is in a first state and the operating body is in proximity to the detection unit, the control unit maintains the signal in the first state, and the transmission unit transmits the signal being in the first state via the signal line,
in the second mode, when the signal is in the first state and the operating body is not in proximity to the detection unit, the control unit changes the signal to be in a second state, and the transmission unit transmits the signal being in the second state via the signal line, and
in the second mode, when the signal is in the second state, the control unit maintains the signal in the second state, and the transmission unit transmits the signal being in the second state via the signal line.

8. The switch system according to claim 7, wherein
the first state is an ON state, and
the second state is an OFF state.

9. The switch system according to claim 7, wherein
the first state is an OFF state, and
the second state is an ON state.

10. The switch system according to any one of claims 7 to 9, wherein
the controller transmits the signal not including the predetermined pattern to the first switch before transmitting the signal including the predetermined pattern to the first switch.

11. The switch system according to any one of claims 7 to 10, wherein
the signal line includes a first signal line and a second signal line,
the controller transmits the signal including the predetermined pattern to the first switch via the first signal line, and transmits the signal not including the predetermined pattern to the first switch via the second signal line, and
the transmission units of the plurality of switches each transmit the signal including the proximity information via the first signal line, and transmit the signal being in the first state or the second state via the second signal line.

12. A switch being one of the plurality of switches in the switch system according to any one of claims 1 to 11, wherein
the switch is connected to the controller by the signal line.

13. A switch being one of the plurality of switches in the switch system according to any one of claims 1 to 11, wherein
the switch is connected to other two of the plurality of switches by the signal line.

14. A switch in a switch system in which a signal transmitted from a controller to one of a plurality of switches is passed through the plurality of switches sequentially via a signal line annularly connecting the controller and the plurality of switches and is returned from one of the plurality of switches to the controller, the switch comprising:
an operating body;
a detection unit configured to detect proximity of the operating body;
a reception unit configured to receive the signal via the signal line;
a control unit configured to determine whether a predetermined pattern is included in the signal; and
a transmission unit configured to transmit the signal via the signal line, wherein
the control unit selects a first mode when the predetermined pattern is included in the signal and selects a second mode when the predetermined pattern is not included in the signal,
in the first mode, the control unit includes, in the signal, proximity information indicating whether the operating body is in proximity to the detection unit, and the transmission unit transmits the signal including the proximity information via the signal line,
in the second mode, when the signal is in a first state and the operating body is in proximity to the detection unit, the control unit maintains the signal in the first state, and the transmission unit transmits the signal being in the first state via the signal line,
in the second mode, when the signal is in the first state and the operating body is not in proximity to the detection unit, the control unit changes the signal to be in a second state, and the transmission unit transmits the signal being in the second state via the signal line, and
in the second mode, when the signal is in the second state, the control unit maintains the signal in the second state, and the transmission unit transmits the signal being in the second state via the signal line.
